# EUROPEAN PATENT APPLICATION

(11) **EP 2 525 389 A1**
(43) Date of publication of application: **21.11.2012**
(21) Application number: 11166618.6
(22) Date of filing: 18.05.2011
(51) Int. Cl.: H01L 21/00, H01L 21/683

(54) **Electrostatic clamp and method of making said electrostatic clamp**

(71) Applicant: Nederlandse Organisatie voor Toegepast -Natuurwetenschappelijk Onderzoek TNO, 2628 VK Delft (NL)
(72) Inventor: te Sligte, Edwin, 2628 VK Delft (NL); Koster, Norbertus Benedictus, 2628 VK Delft (NL)
(74) Representative: Jansen, Cornelis Marinus

(57) **Abstract**

The invention relates to a method of manufacturing an electrostatic clamp. The method comprises providing a base substrate (110) having an electrostatic clamp structure formed on an insulator layer (20) by lithography; providing a planarized carrier having a cavity structure that covers the entire planar surface; forming a stack of the base substrate on the planarized carrier; applying vacuum pressure to the stack of the base substrate and the carrier to vacuumize gas between the base substrate and the carrier and thereby press the base substrate and carrier against each other; drawing, by means of the applied vacuum pressure an adhesive into the cavity structure to form a bonded stack of the base substrate and carrier; and finalizing the stack.

## Description

### FIELD OF INVENTION

The invention relates to a method of manufacturing an electrostatic clamp arranged to electrostatically clamp an article in a lithographic process.

### BACKGROUND

In a lithographic projection apparatus, during photolithographic processes, an article, such as a wafer or reticle is clamped on an article chuck structure by a clamping force, that may range from vacuum pressure forces, electrostatic forces, intermolecular binding forces or just gravity force. The article support defines a plane defining an even flat surface on which the wafer or reticle is held. Tiny variations in the height of these protrusions are detrimental to image resolution, since a small deflection of the article from an ideal plane orientation may result in rotation of the wafer and a resulting overlay error due to this rotation. In addition, such height variations of the article support may result in height variation of the article that is supported thereby. During the lithographic process, such height variations may affect image resolution due to a limited focal distance of the projection system. Therefore it is very critical to have an ideal flat article support. Recently it has been proposed to produce an electrostatic clamp via lithographic techniques. As an example, US patent publication US20070014073 describes a mobile transportable chuck wherein functionality is provided via IC manufacturing technologies. In an alternative method, WO2008/051369 discloses a manufacturing method for an electrostatic clamp, using (pieces of) silicon wafers, which are processed and machined with CVD, PVD processes and photolithographic techniques, and consequently assembled to form an electrostatic clamp. PCT/NL2010/050727 discloses a manufacturing method of an electrostatic clamp by lithography the contents of which are herein incorporated by reference. One of the challenges in a lithographic production process is to manufacture an entirely planar clamp within micrometer accuracy, since the lithographic process may induce small deformations on a wafer scale - due to the various chemical and thermal treatments. This is especially challenging when the aim is to manufacture a two sided clamp.

In the context of this application, the said "article" may be any of the above mentioned terms wafer, reticle, mask, or substrate, more specifically terms such as
- a substrate to be processed in manufacturing devices employing lithographic projection techniques; or
- a lithographic projection mask or mask blank in a lithographic projection apparatus, a mask handling apparatus such as mask inspection or cleaning apparatus, or a mask manufacturing apparatus or any other article or optical element that is clamped in the light path of a radiation system.
- a substrate for printing displays
- a substrate to be processed in vacuum equipment like CVD or PVD apparatus

### SUMMARY OF THE INVENTION

According to an aspect of the invention, a method is provided of manufacturing an electrostatic clamp arranged to electrostatically clamp an article in a lithographic process, the method comprising:
providing a base substrate having an electrostatic clamp structure formed on an insulator layer;
providing a planarized carrier having a cavity structure that covers the entire planar surface;
forming a stack of the base substrate on the planarized carrier;
applying vacuum pressure to the stack of the base substrate and the carrier to vacuumize gas in the cavity structure and thereby press the base substrate and carrier against each other;
drawing, by means of the applied vacuum pressure an adhesive into the cavity structure to form a bonded stack of the base substrate and carrier; and
finalizing the stack.

According to another aspect, an electrostatic clamp is provided that is arranged to electrostatically clamp an article in a lithographic process, the clamp comprising a stack of at least:
a base substrate having an electrostatic clamp structure formed on an insulator layer; and
a planarized carrier having a cavity structure that covers the planar surface; wherein
an adhesive is drawn along the cavity structure to form a bonded stack of the base substrate and carrier in such a way that the base substrate is directly provided on the planarized carrier.

In this way a simple structure can be provided to conveniently provide an electrostatic clamp that may be double sided and that is perfectly planar.

### BRIEF DESCRIPTION OF THE FIGURES

Figure 1 shows a first step in the manufacture of the electrostatic clamp;
Figure 2 shows detail view Figure 1;
Figure 3 schematically shows how a stacking and bonding process;
Figure 4 shows a schematic plan view of setup in the bonding process;
Figure 5 shows a alternative carrier face structure; and
Figure 6 shows an exemplary method for provision of a base substrate for an electrostatic clamp of the Fig 1 embodiment.

### DETAILED DESCRIPTION

In subsequent embodiments the manufacture of a two sided electrostatic clamp will be described. It will be apparent that also a single side clamp may be manufactured within the scope of this invention. The manufacturing involves a process with following steps.

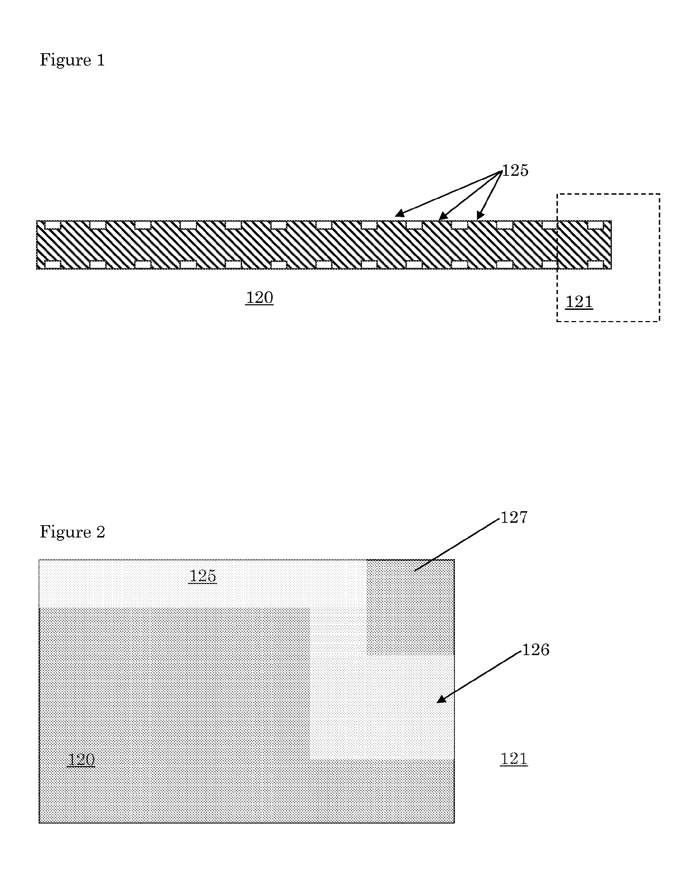

In a first step depicted in Figure 1, a central planarized carrier 120 is provided having a cavity structure 125 that covers the planar surface. The carrier 120 typically has a planarity of less than 10 micrometer. It may typically be formed as a single piece or laminate structure that includes a material of any of the group of SiSiC, Al SiC, Zerodur, ULE, sapphire, float glass, metallic alloy or ceramic. Desired planarity may typically be reached by known planarization methods such as milling grinding and polishing, including chemical mechanical polishing not further described.

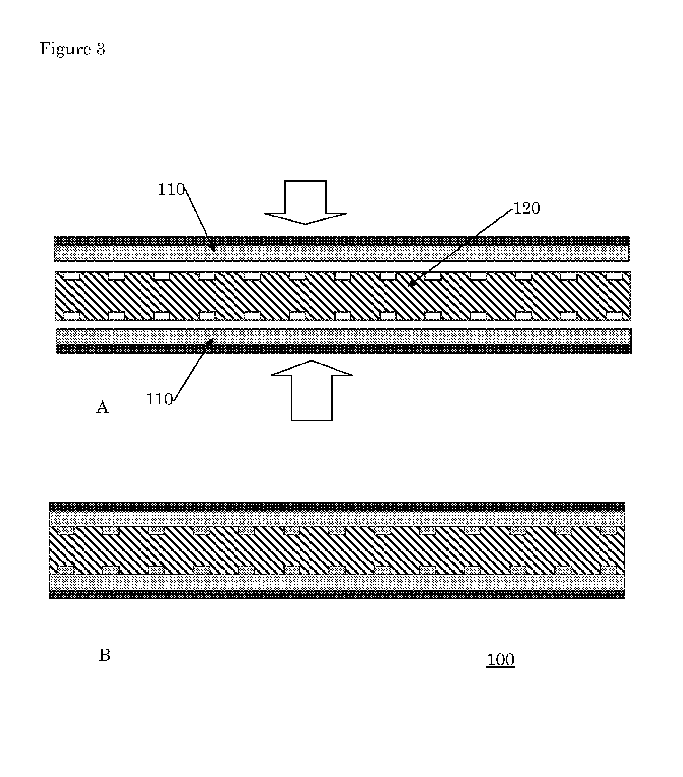

The carrier 120 may be similar to a vacuum "wafer table", which is a rigid structure, usually made of glass type or ceramic materials that provides a flat plane of support to a base substrate 110 to which it is brought in direct contact (see Figure 3). The carrier is provided with a cavity structure 125 the function thereof will be further explained below in conjunction with a second step wherein the assembly parts, in particular, the carrier 120 and base substrate 110 are bonded by drawing, by means of an applied vacuum pressure, an adhesive into the cavity structure to form a bonded stack of the base substrate and carrier.

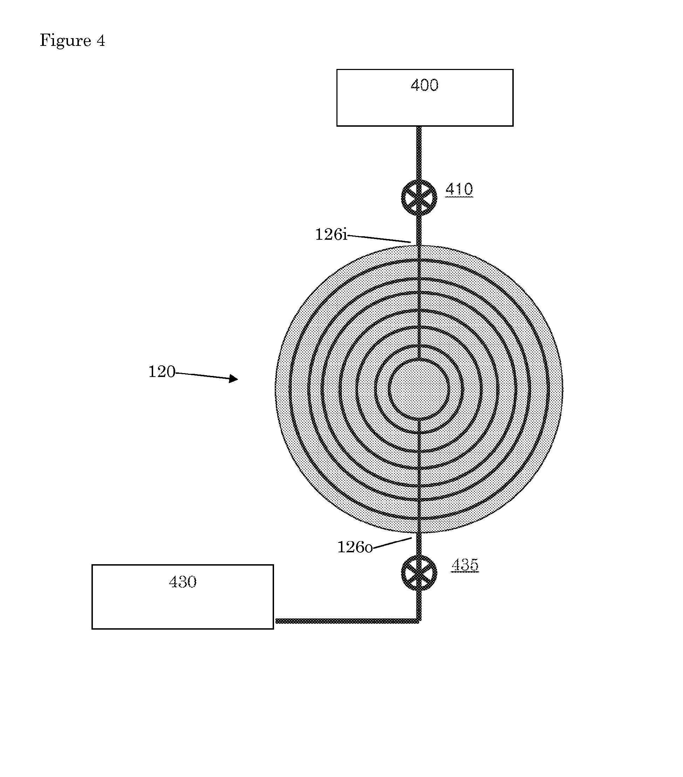

A further advantage of the cavity structure is that it may limit the contact area of the base substrate and the carrier so that any contamination provides minimal distortions of the ideal flat plane of support. As an example of a cavity structure as shown in Figure 1 a groove structure 125 is provided further exemplified in Figure 4.

Alternatively, or possibly in addition, the cavity structure 125 may be provided as a plurality of protrusions for example of a type disclosed in European patent application EP0947884 that describes a wafer table where protrusions are arranged to improve the flatness of the substrate.

Figure 2 shows a detailed view of a side face 121 of carrier 120. The detail concerns an upstanding side face 121 of the carrier 120 wherein the cavity structure 125 is shown to be communicatively connected with an orifice 126 that is provided on an upstanding side face 121 of the carrier 120. The orifice 126 functions as an inlet or outlet connectable to an adhesive supply or a vacuum pressure pump as the case may be which will be further explained below with reference to Figure 4. Thus the cavity structure 125 is designed to facilitate a flow of adhesive in the spaces or cavities formed by the cavity structure 125, where the support structure is entirely flat and may support the 110 base substrate over substantially its entire surface.

Typically the cavity structure has a sealing edge along a perimeter of the carrier 120. The sealing edge 127 forms a seal so that the base substrate 110 is firmly clamped when a vacuum pressure is applied via the orifice 126, thereby sealing the connection between the carrier 120 and the base substrate 110. The orifice 126 forms a tight connection to an exhaust or adhesive feed, for which a dedicated connection may be provided in the carrier 120. The orifice may be round, threaded and with a cross sectional area larger than the grooves.

Figure 3 schematically shows how the stacked components including the base substrate 110 and carrier 120 are vacuum clamped in direct contact onto one another, so that atmospheric pressure flattens any curvature of the base substrate 110. The vacuum pressure is applied via an orifice 126 such as depicted in Figure 2 which functions as an exhaust.

The vacuum pressure is a pressure that is lower than the outside pressure which will typically be atmospheric pressure. In an embodiment, the adhesive is drawn while the stack may be subject to an additional pressure, for example, mechanical clamping or a gas pressure provided to press the stack above atmospheric pressure. When the outside gas pressure is higher than atmospheric, the 'vacuum pressure' can be any convenient pressure below the applied outside pressure. By applying the vacuum pressure, air inclusions may be prevented which could result in deformation, stresses, etc. when clamp is used in practice in a vacuum environment. In addition, the adhesive may be drawn into very narrow (for example a maximum of 5 micrometer thickness or even below 1 micrometer over the entire substrate surface) spaces between top of carrier and bottom of substrate to further enhance the bonding. Accordingly the base substrate can be directly brought in connection to the carrier with adhesive drawn and advancing substantially solely in the cavity structure to ensure planarization of the clamp.

When a sufficient vacuum pressure is built to clamp the substrate 110 and carrier 120 tightly together (Figure 3A), adhesive is inserted via another orifice functioning as feed to bond components (Figure 3B). The adhesive is then drawn into channels by vacuum pressure while vacuum pressure is applied to the stack of the base substrate and the carrier to vacuumize gas between the base substrate and the carrier and thereby press the base substrate and carrier against each other.

In this way a two sided clamp 100 is rendered where, for each side of the carrier 120 a base substrate 110 is provided having an electrostatic clamp structure formed on an insulator layer. The clamp structure is typically formed by lithography, possibly in combination with vapour deposition, plasma treatment etc. In that case the carrier 120 may have on both planar faces a cavity structure 125; and a second base substrate 110 is stacked to form a double sided electrostatic clamp 100.

Figure 4 shows a schematic plan view of the setup for manufacturing the clamp, including an adhesive feed 400 that can be selectively opened and closed via a control valve 410 to provide a controlled feed of adhesive in tight connection with a feeding inlet orifice 126i arranged in the carrier 120 and exhausted via an exhaust outlet orifice 126o, that is coupled to a vacuum pump 430, preferably via a control valve 435. The cavity structure is formed by a branching layout with a single feed and exhaust, wherein the branches cover substantially the entire carrier surface. The sequence of steps is thus as follows: (A) connect vacuum 430 and adhesive 400; (B) place substrate 110 on carrier 120; (C) evacuate grooves 125 by opening valve 435; (D) control valve 410 to feed adhesive to the orifice 126 into the groove configuration; (E) cure the adhesive; and (E) remove connections.

A suitable adhesive can be a commonly available low viscosity epoxy adhesive typically with a viscosity of less then 10000 cps or even less than 100 cps. In addition, the curing should be preferably performed in low temperature conditions, typically room temperature or slightly above, for instance in a range below 100 °C.

A known low viscosity, two component epoxy adhesive is used for general purpose bonding, coating, sealing and casting formulated to cure at room temperature or more rapidly at elevated temperatures with a four (4) to one (1) mix ratio by weight. The adhesive may be 100% reactive and is suitable for low viscosity applications for example in a range of 400-500 cps. Linear shrinkage after cure may be as low 0.0003 inches/in. The adhesive may produce high strength, rigid bonds which are preferably resistant to chemicals and adheres to both similar and dissimilar materials including metals, glass, ceramics, vulcanized rubbers and many plastics. The hardened adhesive may be an electrical insulator. The adhesive can be matched to have a similar low CTE as the carrier material. In an embodiment the thermal conduction through the adhesive and optionally electrical conduction may be enhanced by providing a metal component in the adhesive.

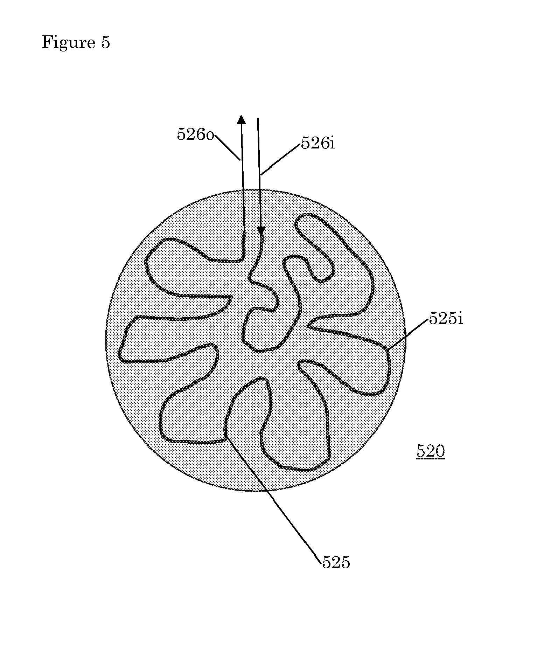

Figure 5 shows a carrier 520 schematic meandering groove structure 525, which is characterized by a cavity structure with unbranched grooves 525i. That is, each groove 525i has a single defined entry 526i and exit 526o connected to adhesive feed and pump respectively, which may further reduce a chance of air inclusion. Multiple segments with multiple in and outlets may be provided.

In a typical arrangement the cavity structure is formed by grooves 525i with an interdistance ranging 5-10 mm and with a groove cross sectional area of 0.01-3 mm2, typically dimensioned in the order of 1x1 mm. In this way, a homogenous bonding over substantially the entire substrate surface of carrier 525 may be provided, for example with a surface area formed by the cavities of more than 50 % or even more than 90% of the substrate surface. The groove sectional area of groove 525i, in particular the groove depth and width is tuned to a viscosity and shrinkage of the adhesive.

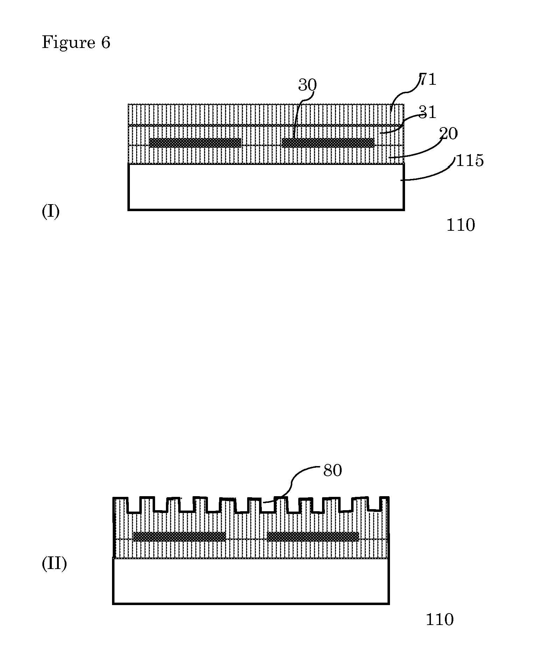

While, the method may be applicable for any type of electrostatic clamp, in particular, of the Johnson Rahbeck type wherein charge moves via a doped dielectric to the surface of the clamp, the present examples disclose an electrostatic clamp utilizing Coulomb electrostatic clamping force. Advantageously a lithographic process allows for production of arbitrary clamp structures, and the inclusion of additional electric modules, such as heater elements or temperature sensors, in the clamp design. According to the example in Figure 6 (I), a base substrate 110 is provided having a patterned conductive layer 30 provided on an insulator 20. The base substrate may comprise a semiconductor base layer 115-or any material common in lithographic processing and is typically a plate structure with a thickness ranging below 3-5 mm which may be slightly warped.

The substrate may comprise a base layer 115 of any of the group of SiSiC, Al, SiC, Zerodur, ULE, saphhire, float glass metallic alloy, ceramic, titanium; which might conveniently combine with the carrier 120 in direct contact to have matching thermal expansion coefficient. Alternatively the substrate 110 can be made from standard silicon plate with a passivation layer (non SOI), glass, aluminium with an anodized surface with a conductive layer of aluminium, Ti, TiN. Typically, such a substrate is a conductive substrate 10, of the known Silicon on Insulator type 110. SOI (Silicon on Insulators) fabrication using buried oxide layers is well known and typically follows basic steps:
1) 02 is implanted onto the silicon substrate at a high dosage (approx. 2e18 cm-2) and energy (150-300 keV);
2) an annealing process at a high temperature (1100-1175 deg C) is done in an inert environment (e.g., using N2) for 3-5 hours, achieving two things: restoration of the crystallinity of the substrate surface and formation of the buried oxide itself; and
3) a layer of epitaxial silicon (which will subsequently serve as the layer over which the circuits will be built) is deposited over the buried oxide. Recently, buried silicon nitride layers (Si3N4) have likewise been successfully used in SOI technology.

The Silicon oxide layer 20 is an electrically insulating layer, and the electrode 30 is conductive and may be formed of a silicon layer. The clamp structure is arranged to be connected to clamping circuitry of a known type not described herein, which typically provides a clamping voltage, so that an electrostatic clamping pressure is generated that may clamp a wafer or any article that is treated in a lithographic process.

For this many variations are possible which are deemed to fall in the scope of the present disclosure.

An optional finishing step may be provided, for example, polishing, providing a wear resistant top layer 71 and/ or preparation for subsequent processing steps. The narrow thickness tolerances on the substrates allow to preserve the surface profile of the clamp within micrometer precision. This ensures that a polishing step after gluing will be small compared to the surface normal dimensions of the clamp structure. The polishing step may achieve surface flatness within 5-100 nm. The finalizing step may include provision of a burl structure and/or polishing of the base substrate to obtain a desired flatness and parallelism.

It is noted, that while the materials used are Silicon and oxidized Silicon, other materials can be contemplated such as Ge, SiN, Ti, TiN or Al in particular, the silicon layer may be doped to provide a JR type clamp or to otherwise tune the electrical conductivity of the materials as desired.

A burl structure 80 is optionally provided on the patterned electrode structure 30. The burls may be made from a range of materials and can be deposited during the lithographic process or etched out of the substrate. The electrostatic gap may be defined in the last step of the manufacturing process by an etch step. At no stage of the production process is any component so thin or fragile that special handling precautions must be taken.

Figure 6 II shows an exemplary step for provision of a burl structure 80. In this example, a top Silicon dioxide layer is directly used for etching a burl structure on top of the electrodes. For this embodiment, the silicon dioxide layer is sufficiently thick for etching a burl structure, and is typically dimensioned with burl gap heights of about 5-10- micron in an insulating top layer 31 preferably sized 7-15 micron thickness after polishing. An additional silicon dioxide layer 71 may be provided by suitable deposition.

For a burl gap height of around 5 micron on a 2 micron oxide layer 31 having a total thickness 7 micron, this amounts to a preferred clamping Voltage of only about 600 V. This is advantageous in comparison with conventional clamping voltages of several kV which are more likely to cause breakdown or discharge. For higher burls 80, for instance, a burl gap height of about 10 micron on a 4 micron oxide layer the clamping Voltage in the clamp will be somewhat higher in the order of about 1200 V.

While the invention has been illustrated and described in detail in the drawings and foregoing description, such illustration and description are to be considered illustrative or exemplary and not restrictive; the invention is not limited to the disclosed embodiments. In particular, unless clear from context, aspects of various embodiments that are treated in various embodiments separately discussed are deemed disclosed in any combination variation of relevance and physically possible and the scope of the invention extends to such combinations.

The skilled artisan will appreciate that, in the context of such alternative applications, any use of the terms "wafer" herein may be considered as synonymous with the more general term "substrate".

Other variations to the disclosed embodiments can be understood and by those skilled in the art in practicing the claimed invention, from a study of the drawings, the disclosure, and the appended claims.

Alternatively the electrodes may be formed of any conducting material such as metals that can be photostructured. In that case the top insulating layer may for example be PECVD Silicon nitride or any other thin film material.

In such cases the isolation toplayer may be deposited by any other means such as for example CVD, PECVD, spin-coating. Materials can be for example silicon-oxide, silicon-nitride, polymers or any other isolating layers that can be deposited in a thin and homogeneous way. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An electrostatic clamp (100) arranged to electrostatically clamp an article in a lithographic process, comprising a stack of at least:
- a base substrate (110) having an electrostatic clamp structure (30) formed on an insulator layer (20); and
- a planarized carrier (120) having a cavity structure (125) that covers the planar surface; wherein
- an adhesive (400) is drawn along the cavity structure (125) to form a bonded stack of the base substrate and carrier in such a way that the base substrate (110) is directly provided on the planarized carrier (120).

2. An electrostatic clamp according to claim 1, wherein the cavity structure has a sealing edge along a perimeter of the carrrier

3. An electrostatic clamp according to claim 1, wherein the cavity structure is communicatively connected with an inlet and an outlet, the inlet connectable to an adhesive supply and the outlet connectable to a vacuum pressure pump, the in- and outlets provided on an upstanding side face of the carrier.

4. An electrostatic clamp according to claim 1, wherein the carrier has on both planar faces a cavity structure; and a second base substrate (110) is stacked to form a double sided electrostatic clamp.

5. An electrostatic clamp according to claim 1, wherein the cavity structure is formed by grooves with an interdistance ranging 5-10 mm and with a groove cross sectional area of 0.5-2 mm2.

6. An electrostatic clamp according to claim 1, wherein the cavity structure has unbranched grooves.

7. An electrostatic clamp according to claim 1, wherein the carrier has a planarity of less than 10 micrometer.

8. An electrostatic clamp according to claim 1, wherein adhesive outside the cavity structure has a maximum thickness of 5 micrometer.

9. An electrostatic clamp according to claim 8, wherein the adhesive is provided solely in the cavity structure.

10. An electrostatic clamp according to claim 1, wherein the base substrate comprises a base layer formed of an insulator; patterned conductive layer (30) forming a conductive clamp structure; and an insulator layer provided thereon.

11. An electrostatic clamp according to claim 1 or 10, wherein the carrier and/or base layer is formed of any of the group of SiSiC, Al, SiC, Zerodur, ULE, saphhire, float glass, metallic alloy or ceramic.

12. An electrostatic clamp according to claim 1, wherein a burl structure (80) is provided in a wear resistant layer (70, 71) provided on the base substrate (110).

13. A method of manufacturing an electrostatic clamp (100) arranged to electrostatically clamp an article in a lithographic process, the method comprising:
- providing a base substrate (110) having an electrostatic clamp structure formed on an insulator layer (20);
- providing a planarized carrier (120) having a cavity structure that covers the entire planar surface;
- forming a stack of the base substrate on the planarized carrier;
- applying vacuum pressure to the stack of the base substrate and the carrier to vacuumize gas in the cavity structure and thereby press the base substrate and carrier against each other;
- drawing, by means of the applied vacuum pressure an adhesive into the cavity structure to form a bonded stack of the base substrate and carrier; and
- finalizing the stack.

14. An electrostatic clamp according to claim 13, wherein finalizing the stack includes provision of a burl structure and/or polishing of the base substrate.

15. A method according to claim 14, wherein the adhesive is drawn while the stack is subject to an additional gas pressure provided to press the stack above atmospheric pressure.
